Europäisches Patentamt

European Patent Office

Office européen des brevets

(11) Publication number: **0 309 274**
A1

# (12) EUROPEAN PATENT APPLICATION

(21) Application number: 88308863.5

(22) Date of filing: 23.09.88

(51) Int. Cl.⁴: **H 01 L 21/60**
H 01 L 21/90

(30) Priority: 25.09.87 US 101037

(43) Date of publication of application:
29.03.89 Bulletin 89/13

(84) Designated Contracting States: DE ES FR GB IT

(71) Applicant: **AMERICAN TELEPHONE AND TELEGRAPH
COMPANY
550 Madison Avenue
New York, NY 10022 (US)**

(72) Inventor: **Huttemann, Robert Donald
5011 Cypress Street
Wescosville Pennsylvania 18106 (US)**

**Tsai, Nun-Sian
3643 Valley Forge Road
Allentown Pennsylvania 18104 (US)**

(74) Representative: **Johnston, Kenneth Graham et al
AT&T (UK) LTD. AT&T Intellectual Property Division 5
Mornington Road
Woodford Green Essex, IG8 OTU (GB)**

(54) Semiconductor device having tungsten plugs.

(57) A metallization scheme useful for integrated circuits uses a buffer layer (e.g., 5) to ensure that the etch back of a contact metal (e.g., 7), such as tungsten, deposited over the buffer layer, can be controlled to form a complete tungsten plug in a via while the tungsten on the dielectric is completely removed. Different etch rates of the buffer and contact materials ensure that, once the buffer layer is exposed, it etches rapidly and the contact material is not significantly etched.

**FIG. 1**

**Description**

**Semiconductor Device Having Tungsten Plugs**

**Technical Field**

This invention relates to the field of semiconductor devices having windows, i.e., vias, in dielectrics that are filled with a metal to form a plug having an essentially planar surface with the surface of the dielectric.

**Background of the invention**

As semiconductor integrated circuits continue to increase their packing densities by containing more devices with ever smaller dimensions, the problems involves in their fabrication, including electrically contacting individual devices, become more severe.

Electrical contacts are typically made by patterning a dielectric to form windows which expose selected portions of the substrate. The windows are filled with a metal to form the contact to the underlying substrate. Aluminum, the metal most commonly used in integrated circuits, is not easily used to fill small windows because of its poor step coverage. Alternatively, a blanket deposition of another metal, e.g., tungsten, which does have good step coverage may be used. The excess metal present on the dielectric surface is removed by etching to leave, in theory, a planar surface formed by the dielectric and the metal.

However, in practice, problems arise because the thickness of the deposited tungsten layer is frequently not uniform across the water. If the etching step clears the dielectric of tungsten on the thicker side, the tungsten in the windows will be severely etched on the thinner side. If the etching just clears the dielectric on the thinner side, the dielectric will not be cleared of tungsten on the thicker side. In neither case will the tungsten and the dielectric form a planar surface. Alternatively, tungsten may be deposited selectively in the windows. However, tungsten is almost invariably deposited, at least to a limited extent, on the dielectric as well. This is, of course, undesirable.

Planar surfaces are desirable because they facilitate subsequent processing. For example, one approach to the problem of electrically contacting the devices simplifies the problem by putting electrical leads on several levels rather than the one level more commonly used at present in integrated circuits. Such an approach simplifies the geometric problems involved in contacting all devices which arise with a single level metal approach. However, the multi-level approach requires the formation of electrical contacts between different metal levels. The problems are similar to those which arise in forming contacts to individual devices. Ultimately, of course, the hope is for circuits with metals on more than two levels as this may allow still more devices per unit area.

**Summary of the Invention**

A semiconductor integrated circuit having a metallization is fabricated by depositing a dielectric layer on a substrate and patterning the layer to form vias, i.e., windows, which expose selected portions of the substrate. A buffer layer, which may be deposited either before or after the dielectric layer is patterned, is deposited. The desired contact material is blanket deposited and etched to form a plug with an essentially planar surface. Both the contact material and the material forming the buffer layer are selected so that once the buffer layer is exposed to the etchant, typically a plasma, the etching of the contact material essentially stops at the top of the windows. That is, when a portion of the buffer layer is exposed, the etching species preferentially reacts with the exposed buffer layer and leaves the contact material, e.g., tungsten, in the windows essentially unetched. Thus, all of the contact material deposited on the dielectric may be easily removed while, because of the presence of the buffer layer, no significant etching of the contact metal within the via occurs. A substantially planar surface across the resulting plug and dielectric layer is obtained. In a preferred embodiment, the contact material is tungsten and is deposited by chemical vapor deposition. An exemplary material for the buffer layer is aluminum.

The method can be repeated more than once if two or more metal levels are desired.

**Brief Description of the Drawing**

FIG. 1 is a schematic diagram of one structure useful in describing the method of the invention;

FIG. 2 is a schematic representation of the structure after etching; and

FIG. 3 is a schematic representation of another structure according to this invention.

For reasons of clarity, the elements depicted are not drawn to scale.

**Detailed Description**

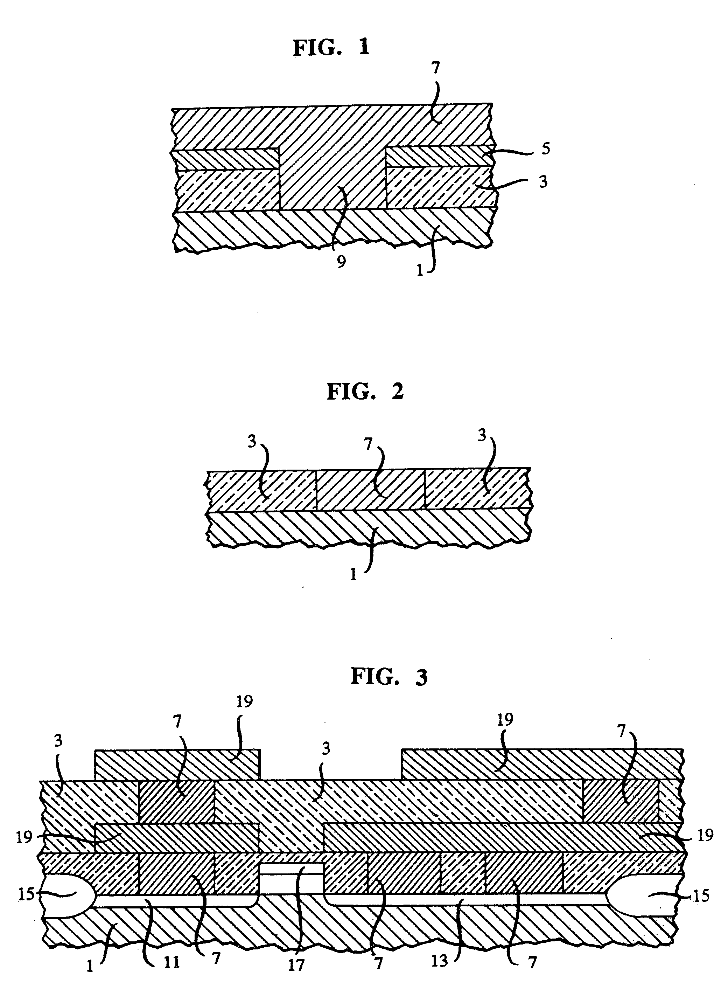

The method of this invention will first be explained by reference to FIG. 1 after which several other exemplary structures will be described. Other variations and embodiments will then be apparent to those skilled in the art. Shown in FIG. 1 are substrate 1, dielectric layer 3, buffer layer 5, and contact layer 7. There is a plurality of windows 9 in dielectric layer 3 and buffer layer 5. As can be seen, the windows have been filled with the contact layer material. The windows, i.e., vias, extend through the dielectric layer and expose selected portions of the substrate.

The term substrate is used to mean any material underlying the dielectric. The substrate material may be Si, Al, etc. and it may comprise device regions such as sources, drains, etc. The dielectric layer comprises any typical and well-known dielectric material such as $SiO_2$ or BPTEOS. The buffer layer comprises materials such as Al, Ti, Ta, $Si_3N_4$, TiN, PSG, etc. The materials are conveniently deposited by, for example, sputtering.

To obtain the structure depicted, both the dielectric layer 3 and buffer layer 5 are deposited and then simultaneously patterned to form windows extending through to the substrate. Standard techniques, well known to those skilled in the art, are used. The buffer layer is relatively thin, typically less than 300 nm thick. The contact material is then deposited, again using well known techniques, to form layer 7. An etch, e.g., a plasma, is now used to remove the contact layer. The choice of the buffer layer material is dictated by the requirement that there exist an etch which etches the buffer layer material but does not etch either the dielectric or the contact material at a rate which is significant compared to the rate at which the buffer material is etched. For example, the contact and buffer layer materials are tungsten and aluminum in a preferred embodiment. The contact layer is etched until portions of the buffer layer are exposed. However, once the buffer layer is exposed to the etching plasma, the etching rate of the contact material in the windows is reduced significantly. For example if the plasma uses $SiF_4$, then the etching species, $F^-$, favors reactions with the exposed buffer layer, Al, and leaves the contact material, W, unattacked. Therefore, significant etching of the material in the window does not occur. Finally, the buffer layer material is stripped using either a wet or a dry etch. Etches using HC1 are suitable. The structure is depicted in FIG. 2. An essentially planar surface is formed by the dielectric and the contact material due to the thinness of the buffer layer.

Alternatively, the dielectric layer may be patterned, and then both the buffer and contact materials deposited. The thinness of the aluminum deposition on the walls of the windows is an asset in this approach.

The materials choice described can result in a fill factor for the plug which is greater than 80 percent. It has been found that the exposed aluminum consumes many of the fluorine atoms by forming non-volatile $AlF_3$ when the tungsten layer is etched to approximately the top of the plug with a fluorine containing etch. By adding an easily ionizable gas such as argon to the etch chemistry, $Ar^+$ ions are formed which sputter remove some of the surface $AlF_3$ thus baring fresh Al which continues the fluorine atom consumption process. Some of the sputter removed $AlF_3$ redeposits and coats the top of the tungsten in the plug areas. Consequently, the combination of reduced number of fluorine atoms and $AlF_3$ passivated tungsten insures that etching of the tungsten stops near the top of the tungsten plug and essentially complete tungsten plugs are formed.

It will be readily appreciated that the process described above with respect to FIGs. 1 and 2 can be readily extended to complicated multilevel metallizations including headless metal patterns, as the described process may be repeated.

An exemplary structure is depicted in FIG. 3. In addition to the elements previously depicted and described, there are source and drain regions, 11 and 13, respectively, field oxides 15, and a gate electrode 17. Two levels of metallization 19 are depicted.

## Claims

1. A method of making a semiconductor integrated circuit having a metallization, the method comprising the steps of:
depositing a dielectric layer (e.g., 3) on a substrate (e.g., 1);
patterning said dielectric to expose selected portions (e.g., 9) of said substrate;
depositing a metallization layer (e.g.,7) so as to at least fill said selected portions and
etching said metallization layer to remove said metallization layer located above said dielectric layer and form an essentially planar surface
**CHARACTERIZED IN THAT**
the method further comprises the step of:
depositing a buffer layer (e.g., 5) on said dielectric layer prior to the metallization layer deposition, said buffer layer comprising a material which etches significantly faster than the metallization layer.

2. A method as recited in claim 1 in which the metallization layer comprises tungsten.

3. A method as recited in claim 2 in which the buffer layer comprises a material selected from the group consisting of aluminum, titanium, tantalum, silicon nitride, titanium nitride and PSG.

4. A method as recited in claim 3 in which the material comprises aluminum.

5. A method as recited in claim 1 in which the buffer layer is deposited before the patterning step is performed.

6. A method as recited in claim 1 in which the etching is by a plasma.

7. A method as recited in claim 6 in which the plasma comprises fluorine, and etching includes an ionizable gas.

8. A method as recited in claim 7 in which the ionizable gas comprises argon.

**FIG. 1**

**FIG. 2**

**FIG. 3**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PROCEEDINGS 1987 VLSI MULTILEVEL INTERCONNECTION CONFERENCE, 15th-16th June 1987, Santa Clara, California, pages 193-199, IEEE; J.-J.LEE et al.: "A study of tungsten etchback for contact and via fill applications" * The whole article * | 1 | H 01 L 21/60 H 01 L 21/90 |
| A | IDEM. | 2-4,6 | |
| A | WO-A-8 704 858 (PLESSEY OVERSEAS LTD) * Claim 1 * | 5 | |
| | | | TECHNICAL FIELDS SEARCHED (Int. Cl.4) |
| | | | H 01 L |

The present search report has been drawn up for all claims

| Place of search | Date of completion of the search | Examiner |
|---|---|---|
| THE HAGUE | 16-12-1988 | PHEASANT N.J. |

EPO FORM 1503 03.82 (P0401)